(19) Europäisches Patentamt

European Patent Office

Office européen des brevets

(11) **EP 1 186 103 B1**

(12) **EUROPÄISCHE PATENTSCHRIFT**

(45) Veröffentlichungstag und Bekanntmachung des Hinweises auf die Patenterteilung:
**04.02.2004 Patentblatt 2004/06**

(21) Anmeldenummer: **00947772.0**

(22) Anmeldetag: **29.05.2000**

(51) Int Cl.$^7$: **H03K 17/567**

(86) Internationale Anmeldenummer:
**PCT/DE2000/001739**

(87) Internationale Veröffentlichungsnummer:
**WO 2000/077934 (21.12.2000 Gazette 2000/51)**

(54) **VERFAHREN UND VORRICHTUNG ZUM ABSCHALTEN EINER KASKODENSCHALTUNG MIT SPANNUNGSGESTEUERTEN HALBLEITERSCHALTUNGEN**

METHOD AND DEVICE FOR DISCONNECTING A CASCODE CIRCUIT WITH VOLTAGE-CONTROLLED SEMICONDUCTOR SWITCHES

PROCEDE ET DISPOSITIF POUR LA DECONNEXION D'UN CIRCUIT CASCODE A COMMUTATEURS A SEMI-CONDUCTEURS COMMANDES EN TENSION

(84) Benannte Vertragsstaaten:
**DE FR GB IT SE**

(30) Priorität: **11.06.1999 DE 19926715**

(43) Veröffentlichungstag der Anmeldung:
**13.03.2002 Patentblatt 2002/11**

(73) Patentinhaber: **SIEMENS AKTIENGESELLSCHAFT 80333 München (DE)**

(72) Erfinder:
• **WEIS, Benno**
  **D-91334 Hemhofen (DE)**
• **BAUDELOT, Eric**
  **D-91085 Weisendorf (DE)**
• **BRUCKMANN, Manfred**
  **D-90475 Nürnberg (DE)**
• **MITLEHNER, Heinz**
  **D-91080 Uttenreuth (DE)**

(56) Entgegenhaltungen:
**DE-C- 19 610 135          US-A- 4 480 201**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren und eine Vorrichtung zum Abschalten einer Kaskodenschaltung, bestehend aus einer Reihenschaltung eines nieder- und hochsperrenden Halbleiterschalters.

In leistungselektronischen Schaltungen können aufgrund von internen Schalthandlungen bzw. externen Netzüberspannungen Spannungswerte an Leistungshalbleitern auftreten, die deren bemessene Sperrfähigkeit überschreiten. Da das Auftreten solcher Betriebszustände nicht ausgeschlossen werden kann, ist eine elementare Forderung zum Schutz von Leistungshalbleiterelementen die Robustheit gegen Überspannungen, um eine Zerstörung der Halbleiterbauelemente oder weitergehende Schäden zu vermeiden.

Für dieses geschilderte Problem existieren derzeit zwei Lösungsmöglichkeiten, nämlich eine passive und eine aktive Überspannungsbegrenzung.

Die passive Überspannungsbegrenzung weist einen Kondensator auf, der elektrisch parallel zum Leistungshalbleiter geschaltet ist. Diese Beschaltung wird auch als Clamp-Schaltung bezeichnet. Mittels dieser Clamp-Schaltung wird die Energie der Überspannung in den Kondensator geleitet, wodurch ein Spannungsanstieg am Leistungshalbleiterschalter begrenzt wird. Dieser Kondensator kann außerdem mit einem Widerstand und einer Diode zu einer sogenannten RCD-Beschaltung erweitert werden, die auch als snubber-circuit bezeichnet wird. Der Nachteil der Clamp-Beschaltung bzw. des snubber-circuit besteht darin, daß der Kondensator für die maximal auftretende Spannung ausgelegt sein muß. Dadurch verursacht dieser Kondensator hohe Kosten und beansprucht ein verhältnismäßig großes Bauvolumen. Ferner wird infolge des großen Bauvolumens und der daraus resultierenden längeren Anschlußleitungen die Streuinduktivität der Beschaltung zunehmen. Die im Kondensator gespeicherte Energie wird, wenn kein weiterer Aufwand betrieben werden soll, mittels des Beschaltungs-Widerstandes in Wärme umgesetzt, wodurch dieser positive Überspannungsschutz eine nicht zu vernachlässigende Verlustleistung verursacht.

Bei einem aktiven Überspannungsschutz wird eine auftretende Überspannung am Leistungshalbleiter erfaßt, mit einem Grenzwert verglichen, der kleiner einer maximalen Sperrspannung des Leistungshalbleiters ist, und der Leistungshalbleiter wird aktiv angesteuert, sobald die Überspannung den vorbestimmten Grenzwert überschreitet. Durch die aktive Ansteuerung ist der Leistungshalbleiter in der Lage, die Energie der Überspannung in Wärme umzusetzen, indem bei hoher Spannung ein erhöhter Strom durch den Leistungshalbleiter fließt. Das Erkennen einer Überspannung kann durch ein spannungsbegrenzendes Bauelement, beispielsweise eine Zenerdiode, erfolgen, das beim Überschreiten seiner Zenerspannung einen Strom in Sperrrichtung führt. Dieser Strom kann direkt oder über einen Verstärker in den Steueranschluß des Leistungshalbleiters geführt werden, um diesen in beschriebener Form aufzusteuern. Beim Überspannungsschutz eines Leistungshalbleiters ist als erwähnte Zenerdiode eine Hochvolt-Zenerdiode notwendig. Anstelle einer hochsperrenden Zenerdiode kann auch ein hochohmiger Spannungsteiler zum Erkennen der Überspannung verwendet werden. Der Nachteil dieses beschriebenen aktiven Überspannungsschutzes liegt darin, daß die Erfassungselemente für die gesamte Sperrspannung des Leistungshalbleiters ausgelegt sein müssen. Ein hochohmiger Spannungsteiler verursacht zudem ständig Verlustleistung, wogegen eine hochsperrende Zenerdiode durch die in ihr umgesetzte Verlustleistung thermisch gefährdet wird. Hochsperrende Bauelemente sind zudem teuer.

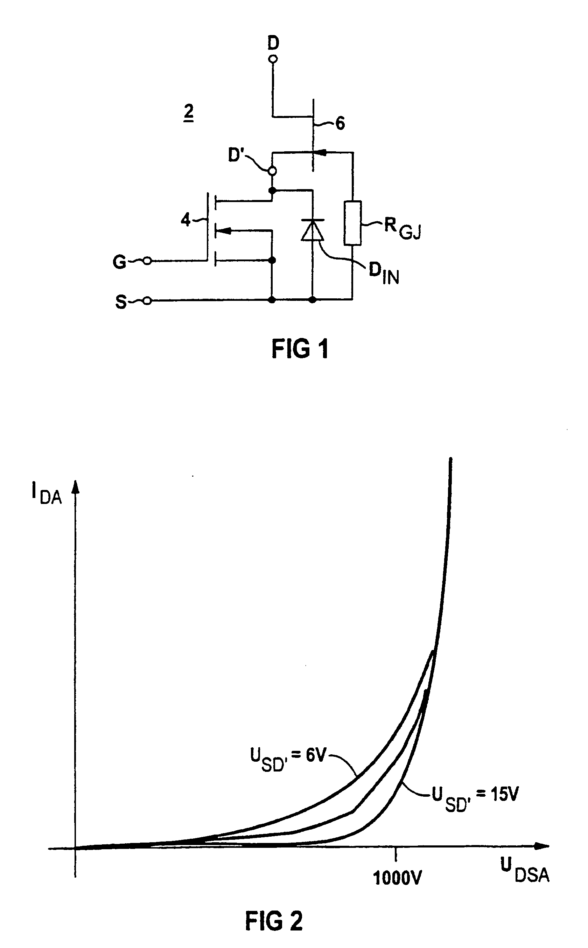

Aus der deutschen Patentschrift 196 10 135 C1 ist eine Kaskodenschaltung zweier elektrisch in Reihe geschalteter spannungsgesteuerter Halbleiterschalter bekannt. Diese Kaskodenschaltung wird anhand der FIG 1 näher beschrieben.

Diese Kaskodenschaltung 2 weist einen nieder- und hochsperrenden Halbleiterschalter 4 und 6 auf, die elektrisch in Reihe geschaltet sind. Als niedersperrender Halbleiterschalter 4 ist ein selbstsperrender n-Kanal-MOSFET, insbesondere ein Niedervolt-Leistungs-MOSFET, vorgesehen, wobei als hochsperrender Halbleiterschalter 6 ein n-Kanal-Sperrschicht-FET vorgesehen ist. Dieser hochsperrende Sperrschicht-FET 6 wird auch als Junction-Field-Effect-Transistor (JFET) bezeichnet. Diese beiden FET 4 und 6 sind derart elektrisch in Reihe geschaltet, daß der Source-Anschluß des Sperrschicht-FET 6 direkt mit dem Drain-Anschluß D' des MOSFET 2 und daß der Gate-Anschluß des Sperrschicht-FET 6 mittels eines Gate-Widerstandes $R_{GJ}$ mit dem Source-Anschluß S' des MOSFET 4 elektrisch leitend verbunden sind. Diese elektrische Zusammenschaltung zweier Halbleiterbauelemente wird bekanntlich als Kaskodenschaltung bezeichnet. Da als Halbleiterschalter 4 und 6 der Kaskodenschaltung 2 jeweils FET verwendet werden, wird diese Kaskodenschaltung 2 auch als Hybrid-Leistungs-MOSFET bezeichnet. Der niedersperrende MOSFET 4 dieser Kaskodenschaltung 2 weist eine interne bipolare Diode $D_{IN}$ auf, die antiparallel zum MOSFET 4 geschaltet ist und allgemein als Inversdiode bzw. interne Freilaufdiode bezeichnet wird. Der selbstsperrende n-Kanal-MOSFET 2 ist aus Silizium, wogegen der selbstsperrende n-Kanal-JFET 6 vorzugsweise aus Siliziumkarbid besteht. Dieser Hybrid-Leistungs-MOSFET 2 ist für eine hohe Sperrspannung von über 1000 V ausgelegt und weist dennoch nur geringe Verluste im Durchlaßbereich auf.

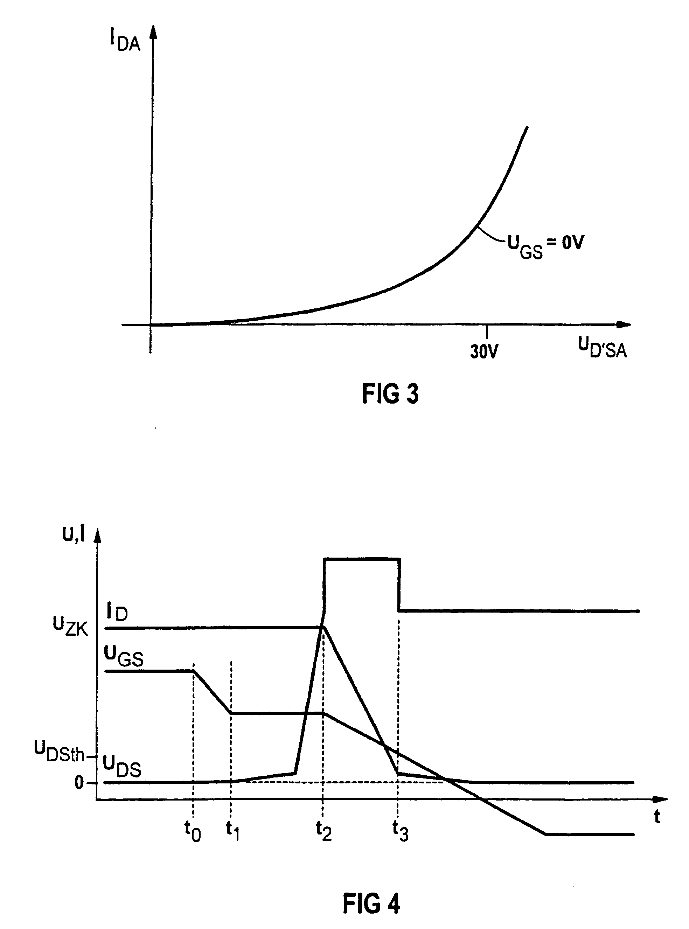

In den FIG 2 und 3 sind jeweils Sperrkennlinien des selbstleitenden n-Kanal-JFET 6 und des selbstsperrenden n-Kanal-MOSFET 4 in einem Diagramm über der Zeit t dargestellt. Da in der Kaskodenschaltung 2 der nieder- und hochsperrender Halbleiterschalter 4 und 6 elektrisch in Reihe geschaltet sind, muß der Strom durch beide Halbleiterschalter 4 und 6 gleich groß sein. Zudem liegt die Sperrspannung $U_{DSA}$ des niedersperrenden Halbleiterschalters 4 als Gatespannung am hochsperrenden Halbleiterschalters 6 der Kaskodenschaltung 2 an. Liegt nun an der abgeschalteten Kaskodenschaltung 2 eine Sperrspannung $U_{DSA}$ an, so wird sich diese auf beide Halbleiterschaltung 4 und 6 der Kaskodenschaltung 2 aufteilen. Diese Aufteilung wird so erfolgen, daß sich für beide Halbleiterschalter der gleiche Sperrstrom $I_{DA}$ einstellen. Auf diese Art wird sich ein stabiler Betriebspunkt AP einstellen.

Sollte sich von einem stabilen Betriebspunkt AP der Kaskodenschaltung 2 der Wert der Sperrspannung $U_{D'SA}$ des niedersperrenden Halbleiterschalters 4 sich zu niedrigen Werten verlagern, so müßte der Sperrstrom $I_{DA}$ gemäß der Sperrkennlinie nach FIG 3 ebenfalls absinken. Für den hochsperrenden Halbleiterschalter 6 bedeutet dies nur eine marginale Veränderung seiner Sperrspannung $U_{DSA}$, da diese wesentlich größer als die Sperrspannung $U_{D'SA}$ des niedersperrenden Halbleiterschalters 4 ist. Eine Abnahme der Sperrspannung $U_{D'SA}$ des niedersperrenden Halbleiterschalters 4 der Kaskodenschaltung 2 bedeutet jedoch ebenfalls eine betragsmäßige Abnahme der Gatespannung des hochsperrenden Halbleiterschalters 6. Eine betragsmäßig kleinere Gatespannung des hochsperrenden Halbleiterschalters 6 bedeutet jedoch einen erhöhten Sperrstrom $I_{DA}$ (FIG 2). Dieser erhöhte Sperrstrom $I_{DA}$ kann jedoch vom niedersperrenden Halbleiterschalter 4 der Kaskodenschaltung 2 nur geführt werden, wenn dieser eine größere Sperrspannung aufnimmt. Somit ist die zuvor gedachte Abnahme der Sperrspannung $U_{D'SA}$ des niedersperrenden Halbleiterschalters 4 der Kaskodenschaltung 2 aufgehoben.

Dieser Umstand läßt sich für eine Überspannungserkennung ausnutzen, wobei ein Niedervoltsignal zur Detektion einer Überspannung auf Hochpotential verwendet wird.

Der Erfindung liegt nunmehr die Aufgabe zugrunde, eine Überspannung auf Hochpotential mittels eines Niedervoltsignals detektieren zu können.

Diese Aufgabe wird erfindungsgemäß mit den Merkmalen des Anspruchs 1 bzw. 3 gelöst.

Dadurch, daß mit Eintreffen eines Ausschalt-Signals die Gatespannung des niedersperrenden Halbleiterschalters so geregelt wird, daß seine Drainspannung konstant in einem aktiven Bereich des niedersperrenden Halbleiterschalters der Kaskodenschaltung erhalten wird, erhält man ein Niedervoltsignal, das anzeigt, ob auf Hochpotential der Kaskodenschaltung eine Überspannung auftritt.

Dadurch, daß die Drainspannung des niedersperrenden Halbleiterschalters der Kaskodenschaltung konstant im aktiven Bereich geregelt wird, kann beim Auftreten einer Überspannung wegen der konstanten Gatespannung nur der Drainstrom durch die Kaskodenschaltung ansteigen. Dieser Stromanstieg kann nur vom niedersperrenden Halbleiterschalter der Kaskodenschaltung geführt werden, wenn bei konstanter Drainspannung die Gate-Spannung derart verändert wird, daß der niedersperrende Halbleiterschalter wieder aufgesteuert wird. Das heißt, die Richtung der Gatespannungsänderung wird geändert. Diese Änderung der Gatespannung wird auf Niederpotential abgegriffen und ist ein Indiz für das Auftreten einer Überspannung auf Hochpotential der Kaskodenschaltung.

Da für die Regelung der Drainspannung des niedersperrenden Halbleiterschalters der Kaskodenschaltung neben einen vorbestimmten Sollwert auch der Istwert der Drainspannung benötigt wird, kann auch dieses erforderliche Niedervoltsignal hinsichtlich einer Überspannungsdetektion ausgewertet werden. Im Normalfall entspricht der Wert dieses ermittelten Drainspannungs-Istwertes annähernd dem Wert des Drainspannungs-Sollwertes. Tritt beim Ausschalten bzw. im gesperrten Zustand der Kaskodenschaltung eine Überspannung auf, so steigt der Drainspannungs-Istwert des niedersperrenden Halbleiterschalters der Kaskodenschaltung schnell an. Dieser Anstieg des Drainspannungs-Istwertes ist dann ein Indiz für die Überspannung auf Hochpotential der Kaskodenschaltung.

Als Vorrichtung zum Abschalten einer Kaskodenschaltung ist ein Regelkreis, bestehend aus einem Vergleicher und einem Regler, vorgesehen, der beim Abschalten der Kaskodenschaltung und wahlweise auch im ausgeschalteten Zustand mit dem Gate-Anschluß des niedersperrenden Halbleiterschalters dieser Kaskodenschaltung verknüpft ist. Dieser Regelkreis auf Niederpotential bietet mehrere Signale an, die zur Überspannungsdetektion ausgewertet werden können. Welches Signal sich für die Uberspannungsdetektion anbietet, hängt von der Ausgestaltung des Reglers bzw. von der Dynamik des Regelkreises ab. Ein Vorzeichenwechsel in dem Drainspannungs-Differenzwert ist ein Indiz für das Auftreten einer Überspannung auf Hochpotential der Kaskodenschaltung. Ebenso kann der Anstieg des Drainspannungs-Istwertes des niedersperrenden Halbleiterschalters als Detektorsignal bezüglich des Auftretens einer Uberspannung auf Hochpotential der Kaskodenschaltung verwendet werden.

Mit diesem erfindungsgemäßen Abschaltverfahren einer Kaskodenschaltung kann man mit Hilfe eines Niederpotentialsignals das Auftreten einer Überspannung auf Hochpotential der Kaskodenschaltung detektieren, wobei die Kaskodenschaltung die Energie der Überspannung in Wärme umsetzt. Am Ende des Ausschaltvorgangs ist der hochsperrende Halbleiterschalter und der niedersperrende Halbleiterschalter im Sperrzustand. Die Drainspannung des niedersperrenden Halbleiterschalters wird im Sperrzustand entweder über seine Gatespannung auf einen vorbestimmten konstanten Wert geregelt oder stellt sich bei abgeschaltetem Gate auf einen beliebigen Wert ein.

Somit besteht nicht nur die Möglichkeit mittels des erfindungsgemäßen Abschaltverfahrens einer Kaskodenschaltung eine Überspannung auf Hochpotential zu detektieren, sondern diese Überspannung gleichzeitig aktiv zu begrenzen.

Vorteilhafte Ausführungsformen der Vorrichtung zum Abschalten einer Kaskodenschaltung sind den Unteransprüchen 4 bis 11 zu entnehmen.

Zur näheren Erläuterung der Erfindung wird auf die Zeichnung Bezug genommen, in der eine Ausführungsform der erfindungsgemäßen Vorrichtung schematisch veranschaulicht ist.

| | |
|---|---|
| FIG 1 | zeigt die Schaltung eines bekannten Hybrid-Leistungs-MOSFET, die |
| FIG 2 und 3 | zeigen jeweils in einem Diagramm über der Zeit t die Sperrkennlinien des nieder- und hochsperrenden Halbleiterschalters des Hybrid-Leistungs-MOSFET gemäß FIG 1, die |
| FIG 4 | zeigt in einem Diagramm über der Zeit t einen Ausschaltvorgang einer Kaskodenschaltung, die |
| FIG 5 | veranschaulicht eine Vorrichtung gemäß der Erfindung, wobei in der |
| FIG 6 | eine Steuerkennlinie des niedersperrenden Halbleiterschalters der Kaskodenschaltung in einem Diagramm über der Zeit t dargestellt ist, die |
| FIG 7 und 8 | zeigen jeweils in einem Diagramm über der Zeit t eine Ausgangskennlinie des nieder- und hochsperrenden Halbleiterschalters der Kaskodenschaltung nach FIG 1, in der |
| FIG 9 | ist die Struktur des Regelkreises gemäß FIG 5 näher dargestellt, wobei in der |
| FIG 10 | eine vorteilhafte Ausführungsform des Reglers nach FIG 9 dargestellt ist und die |
| FIG 11 | zeigt eine erfindungsgemäße Vorrichtung mit einer weiteren Ausführungsform der Kaskodenschaltung. |

In der FIG 4 ist ein Abschaltvorgang eines Leistungs-MOSFET schematisch dargestellt. Um einen Leistungs-MOSFET abschalten zu können, muß das Potential des Gates G bis auf Source-Potential entladen werden. In der Regel legt man das Gate-Potential auf (gegenüber Source) negatives Potential um Störungen entgegenzuwirken. Das Entladen des Gates G geschieht über einen Gate-Entladewiderstand, der auch gleichzeitig der Gate-Ladewiderstand sein kann. Der Entladevorgang beginnt zum Zeitpunkt $t_0$ und fällt zunächst bis zum sogenannten Miller-Plateau (Zeitpunkt $t_1$), das abhängig vom Laststrom ist, ab. Hier werden zunächst die parasitären Kapazitäten umgeladen. Die Drain-Source-Spannung $U_{DS}$ steigt zum Zeitpunkt $t_1$ (Miller-Plateau) an. Erreicht die Drain-Source-Spannung $U_{DS}$ den Wert der Zwischenkreisspannung $U_{ZK}$ (Zeitpunkt $t_2$), so kann eine Freilaufdiode den Strom vom Leistungs-MOSFET übernehmen und der Drainstrom $I_D$ fällt. Gleichzeitig sinkt die Gate-Source-Spannung $U_{GS}$. Die Stromfallzeit läßt sich durch eine Art der Ansteuerung (geringer oder hoher Entladestrom der Steuerkapazität) beeinflussen und endet zum Zeitpunkt $t_3$. Ab diesem Zeitpunkt $t_3$ fließt durch das Leistungs-MOSFET nur noch ein Tailstrom, der aus der gespeicherten Ladung des Bauelementes resultiert. Im Gegensatz zu den vorherigen Phasen des Abschaltvorganges hat man über die Steuerung keinen Einfluß auf den Tailstrom. Während des Stromabfalles überschreitet die Drain-Source-Spannung $U_{DS}$ am Leistungs-MOSFET die Zwischenkreisspannung $U_{ZK}$ bedingt durch Streuinduktivitäten. Der Abschaltvorgang kann durch Änderung des Wertes des Gate-Entladewiderstandes beeinflußt werden. Ein kleiner Widerstandswert bedeutet einen großen Stromfluß aus dem Gate G des Leistungs-MOSFET heraus, somit ein schnelles Umladen, eine höhere Spannungsanstiegsgeschwindigkeit und eine höhere Stromfallgeschwindigkeit bei den einzelnen Schaltvorgängen.

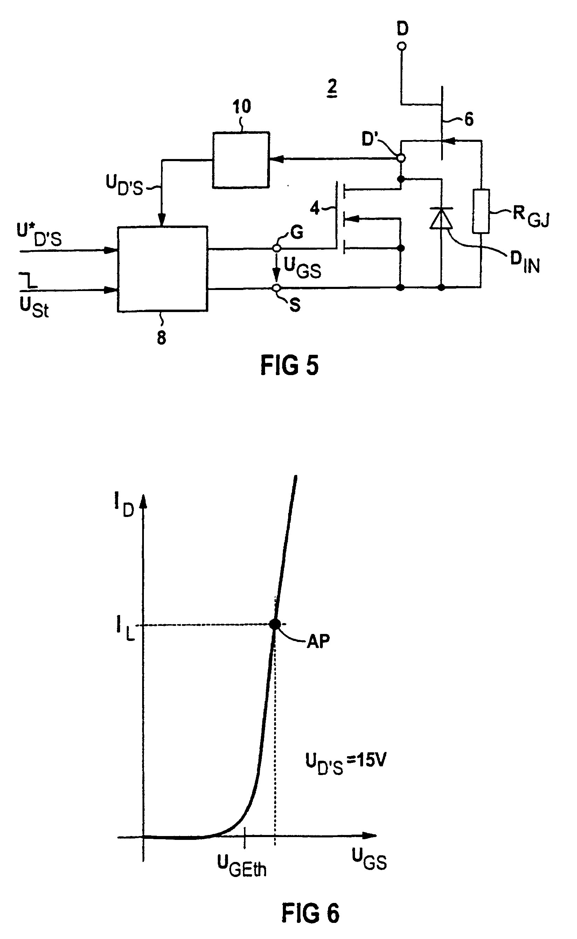

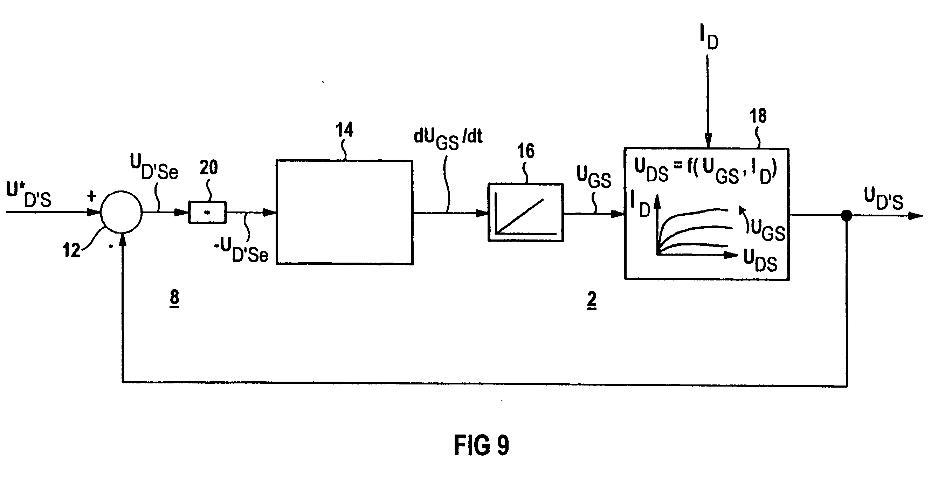

Die FIG 5 zeigt eine bekannte Kaskodenschaltung 2 mit einer Vorrichtung 8 gemäß der Erfindung. Diese Vorrichtung 8 ist ausgangsseitig mit dem Gate- und dem Source-Anschluß G und S des niedersperrenden Halbleiterschalters 4 der Kaskodenschaltung 2 verknüpft. An einem Istwert-Eingang dieser Vorrichtung 8 steht ein Drainspannungs-Istwert $U_{D'S}$ des niedersperrenden Halbleiterschalters 4 der Kaskodenschaltung 2 an, wogegen am Sollwert-Eingang ein Drainspannungs-Sollwert $U^*_{D'S}$ ansteht. An einem Steuereingang steht ein Ausschaltbefehl $U_{St}$ an, der diese Vorrichtung 8 aktiviert. Der Drainspannungs-Istwert $U_{D'S}$ wird in bekannter Weise mittels einer Einrichtung 10 ermittelt. Diese Einrichtung 10 ist eingangsseitig mit dem Drain-Anschluß D' des niedersperrenden Halbleiterschalters 4 der Kaskodenschaltung 2 verknüpft. Die Regelkreisstruktur dieser Ausführungsform ist in der FIG 9 näher dargestellt.

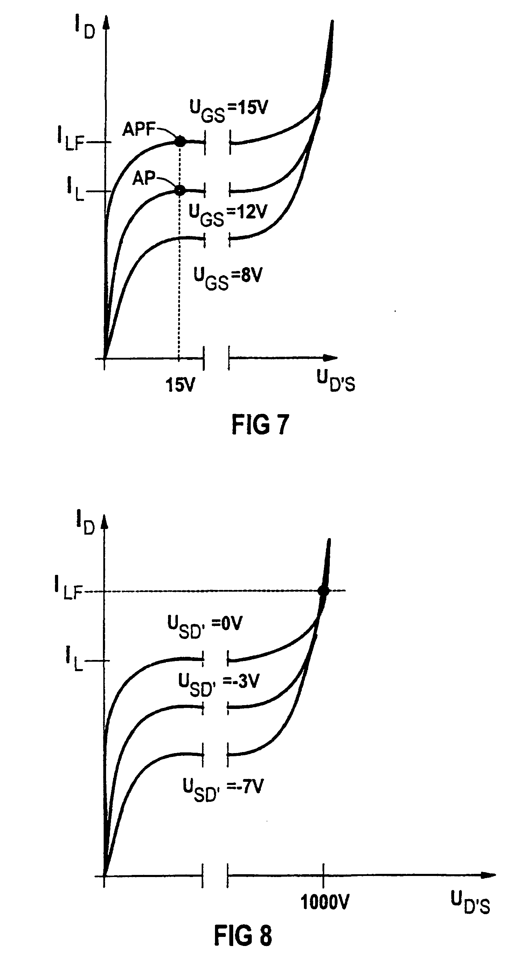

In der FIG 6 ist eine Steuerkennlinie eines selbstsperrenden n-Kanal-MOSFET 4 der Kaskodenschaltung 2 für eine konstante Drainspannung $U_{D'S}$ von beispielsweise 15 V in einem Diagramm über die Gatespannung $U_{GS}$ näher dargestellt. In Abhängigkeit eines Laststromes $I_L$ stellt sich ein Arbeitspunkt AP ein. Zugehörige Ausgangskennlinien des selbstsperrenden n-Kanal-MOSFET 4 der Kaskodenschaltung 2 sind in dem Diagramm der FIG 7 dargestellt. Gemäß diesem Ausgangskennlinienfeld ist jeder Ausgangskennlinie eine Gatespannung $U_{GS}$ zugeordnet. Das Ausgangskennlinienfeld des selbstleitenden n-Kanal-JFET 6 der Kaskodenschaltung 2 entspricht dem Ausgangskennlinienfeld des selbstsperrenden n-Kanal-MOSFET 4. Ein derartiges Kennlinienfeld ist in der FIG 8 dargestellt. Der Unterschied dieses Kennlinienfeldes zum Kennlinienfeld nach FIG 7 besteht darin, daß der ausgeblendete Bereich wesentlich größer ist, und daß sich die Gatespannung $U_{GS}$ um ca. 15 V zu niedrigen Werten verschoben hat. Die Gatespannung $U_{GS}$ des selbstleitenden n-Kanal-JFET 6 ist gleich der negativen Drainspannung $U_{D'S}$ des selbstsperrenden n-Kanal-MOSFET 4 der Kaskodenschaltung 2.

Die FIG 9 zeigt eine Regelkreisstruktur des niedersperrenden Halbleiterschalters 4 mit der Vorrichtung 8 nach FIG 5. Diese Vorrichtung 8 weist einen Vergleicher 12 und eine Regeleinrichtung 14 auf. Der niedersperrende Halbleiterschalter 4 der Kaskodenschaltung 2 ist durch einen Integrierer 16 und einen Kennliniengeber 18 veranschaulicht. Der Integrierer 16 stellt die Eingangskapazität am Steuereingang des niedersperrenden Halbleiterschalters 4 der Kaskodenschaltung 2 dar. Der Kennliniengeber 18 weist die Ausgangskennlinien des niedersperrenden Halbleiterschaltes 4 der Kaskodenschaltung 2 auf. Dazu ist dem Kennliniengeber 18 auch der Drainstrom $I_D$, der durch die Kaskodenschaltung 4 fließt, zugeführt. Ausgangsseitig ist der Kennliniengeber 18 mit dem invertierenden Eingang des Vergleichers 12 verknüpft, an dessen nichtinvertierenden Eingang ein Drainspannungs-Sollwert $U_{D'S}^*$ ansteht. Der Ausgang dieses Vergleichers 12 ist mittels einer Vorzeichenwechsel-Einrichtung 20 mit einem Eingang der Regeleinrichtung 14 verbunden.

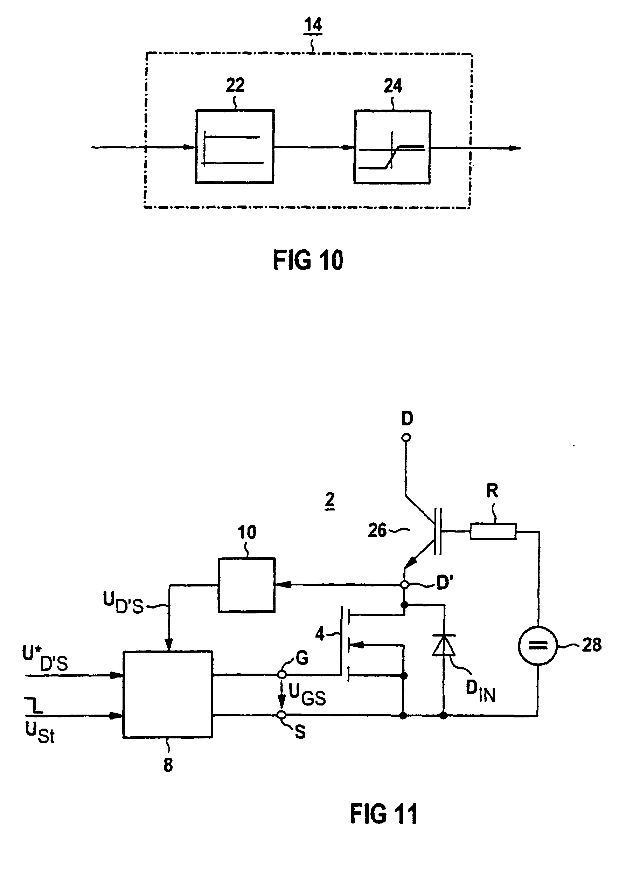

Gemäß der FIG 10 weist die Regeleinrichtung 14 einen Regler 22 und eine Begrenzereinrichtung 24 auf. Diese Ausführungsform der Regeleinrichtung 14 ist eine Ausführungsform. Auf die Begrenzereinrichtung 24 kann auch verzichtet werden, ohne daß sich am Abschaltverfahren etwas ändert. Als Regler 22 ist in der Ausführungsform gemäß FIG 10 ein Proportionalregler, auch als P-Regler bezeichnet, vorgesehen.

Anhand dieser beiden FIG 9 und 10 in Verbindung mit den FIG 4, 6 bis 8 soll nun das erfindungsgemäße Verfahren zum Abschalten einer Kaskodenschaltung 2, bestehend aus einem nieder- und hochsperrenden Halbleiterschalter 4 und 6, näher erläutert werden:

Zu Beginn des Abschaltvorgangs (Zeitintervall $t_2$-$t_0$ der FIG 4) wird die Gatespannung $U_{GS}$ des selbstsperrenden n-Kanal-MOSFET 4 so geregelt, daß die Drainspannung $U_{D'S}$ des selbstsperrenden n-Kanal-MOSFET 4 konstant im aktiven Bereich gehalten wird. Dazu wird ein Drainspannungs-Sollwert $U_{D'S}^*$ von beispielsweise 15 V vorgegeben. Gemäß der Steuerkennlinie nach FIG 6 stellt sich mit dieser Drainspannung $U_{D'S}$ = 15 V und einem Laststrom $I_L$ der Arbeitspunkt AP ein. Für den selbstleitenden n-Kanal-JFET 6 der Kaskodenschaltung 2 wirkt diese auf 15 V geregelte Drainspannung $U_{D'S}$ des selbstsperrenden n-Kanal-MOSFET 4 als Eingangsspannung an dessen Gate. Durch den Gate-Widerstand $R_{GJ}$ und die nicht näher dargestellte Eingangskapazität des selbstleitenden n-Kanal-JFET 6 wird der Abschaltvorgang des JFET 6 eingeleitet.

Nach Ablauf der Zeitverzögerung, die in Abhängigkeit des Gatewiderstandes $R_{GJ}$ bestimmt wird, steht am Gate des JFET 6 die geregelte Drainspannung $U_{D'S}$ des MOSFET 4 mit umgekehrter Polarität an, so daß der JFET 6 ausgeschaltet ist. Dieser Verlauf des Verfahrens findet in dieser beschriebenen Weise statt, wenn beispielsweise zum Zeitpunkt $t_2$ (FIG 4) keine unzulässige Überspannung auftritt.

Tritt jedoch am selbstleitenden n-Kanal-JFET 6 der Kaskodenschaltung 2 eine unzulässige Überspannung in Zeitintervall $t_3$-$t_2$ (FIG 4) auf, so steigt der Laststrom $I_L$ auf $I_{LF}$ an. Der Arbeitspunkt des JFET 6 hat sich bei Auftreten einer unzulässigen Überspannung in dem Bereich der exponentiell ansteigenden Kurven verlagert (FIG 8). Dieser Stromanstieg kann vom selbstsperrenden n-Kanal-MOSFET 4 der Kaskodenschaltung 2 nur dann geführt werden, wenn dieser MOSFET 4 wieder aufgesteuert wird. Gemäß FIG 7 befindet sich beispielsweise MOSFET 4 vor dem Zeitpunkt $t_2$ im Arbeitspunkt AP. Nach diesem Zeitpunkt $t_2$ befindet sich der MOSFET 4 im Betriebspunkt APF, da nun durch die Kaskodenschaltung 2 der erhöhte Laststrom $I_{LF}$ fließt. Da die Drainspannung $U_{D'S}$ des selbstsperrenden n-Kanal-MOSFET 4 der Kaskodenschaltung 2 durch das Verfahren auf beispielsweise 15 V geregelt wird, kann dieser MOSFET 4 den erhöhten Strom $I_{LF}$ nur dann führen, wenn die Gate-Spannung $U_{GS}$ von 12 V auf 15 V wieder erhöht wird. Dies bedeutet eine Umkehrung der Gatespannungsänderung $dU_{GS}/dt$. Durch das Wiederaufsteuern des MOSFET 4 der Kaskodenschaltung 2 wird aktiv die Energie der unzulässigen Überspannung in der Kaskodenschaltung 2 in Wärme umgesetzt. Das heißt, beim Auftritt einer unzulässigen Überspannung wird diese mit dem erfindungsgemäßen Abschaltverfahren aktiv begrenzt.

Da im fehlerfreien Abschaltvorgang die Gatespannungsänderung $dU_{GS}/dt$ sich nicht umkehrt, wird die Stromänderung zu größeren Werten hin durch die Umkehrung der Gatespannungsänderung $dU_{GS}/dt$ detektiert. Somit zeigt dieses Signal eine unzulässige Überspannung auf Hochpotential an, ohne daß die Spannung auf Hochpotential ausgewertet werden muß.

Mit dieser Vorrichtung zum Abschalten einer Kaskodenschaltung 2 kann man mit einer kleinen Abänderung auch eine Überspannung, beispielsweise eine externe Netzüberspannung, im Sperrzustand der Kaskodenschaltung 2 detektieren. Dazu wird das Ausgangssignal $U_{GS}$ des Integrierers 16 auf einen Startwert gesetzt, der den selbstsperrenden n-Kanal-MOSFET 4 sicher abschaltet. Im allgemeinen kann der Wert der negativen Versorgungsspannung der Ansteuerschaltung verwendet werden. Infolge dieses negativen Spannungswertes der Gatespannung $U_{GS}$ des niedersperrenden n-Kanal-MOSFET 4 stellt sich eine Drainspannung $U_{D'S}$ ein. Diese sich einstellende Drainspannung $U_{D'S}$ des niedersperrenden n-Kanal-MOSFET im Sperrzustand wird als Drainspannungs-Sollwert $U_{D'S}^*$ verwendet. Somit ist der Regelkreis wieder im Eingriff. Wenn wegen eines Anstieges der Sperrspannung der Kaskodenschaltung 2 auch der Drainspannungs-Istwert $U_{D'S}$ des niedersperrenden n-Kanal-MOSFET 4 ansteigt, erscheint am Eingang der Regeleinrichtung 14 eine von Null verschiedene Regeldifferenz $U_{D'Se}$. Diese von Null verschiedene Regeldifferenz $U_{D'Se}$ zeigt an, daß im statischen Sperrfall eine Überspannung an der Kaskodenschaltung 2 ansteht. Somit kann man mit dieser beschriebenen Abänderung der erfindungsgemäßen Vorrichtung im statischen Sperrfall eine Überspannung an der Kaskodenschaltung 2 detektieren, ohne dabei den Hochspannungsanschluß der Kaskodenschaltung 2 für eine Istwert-Erfassung verwenden zu müssen.

Wird eine Regeleinrichtung 14 gemäß FIG 10 verwendet, so kann die Gatespannung $U_{GS}$ des MOSFET 4 der Kaskodenschaltung 2 zwar schnell abgesenkt werden, aber nicht schnell erhöht werden. Dadurch wird die Drainspannung $U_{D'S}$ des MOSFET 4 bei der nun konstanten Gatespannung $U_{GS}$ schnell ansteigen. Auch dieses Signal kann für die Erkennung einer unzulässigen Überspannung genutzt werden. Sobald eine unzulässige Überspannung mittels des Drainspannungs-Istwertes $U_{D'S}$ detektiert ist, muß für die Begrenzung der Überspannung die Begrenzereinrichtung 24 deaktiviert werden. Die Begrenzung der Überspannung erfolgt wieder durch ein leichtes Wiederaufsteuern des MOSFET 4 der Kaskodenschaltung 2 bis zum Ende des Schaltvorgangs.

Die FIG 11 zeigt eine erfindungsgemäße Vorrichtung mit einer weiteren Ausführungsform der Kaskodenschaltung 2. Gegenüber der Ausführungsform nach FIG 5 unterscheidet sich diese Ausführungsform der Kaskodenschaltung 2 nur dadurch, daß anstelle eines JFET 6 als hochsperrender Halbleiterschalter ein Spannungsgesteuerter Halbleiterschalter 26 vorgesehen ist. Bei der Verwendung eines spannungsgesteuerten Halbleiterschalters 26 als hochsperrender Halbleiterschalter 6 der Kaskodenschaltung 2 ist ein Gate-Anschluß dieses spannungsgesteuerten Halbleiterschalters 26 mittels eines Gatewiderstandes R und einer Konstantspannungsquelle 28 mit dem Source-Anschluß S des niedersperrenden Halbleiterschalters 4 der Kaskodenschaltung 2 verbunden. Als Konstantspannungsquelle 28 wird eine Gleichspannungsquelle, beispielsweise eine Batterie von etwa 15 V, verwendet. Als spannungsgesteuerter Halbleiterschalter 26 kann beispielsweise ein Insulated-Gate-Bipolar-Transistor (IGBT), ein MOSFET, ein MOS-gesteuerter Thyristor (MCT),... verwendet werden, wobei hier nur ein IGBT als hochsperrender Halbleiterschalter 6 der Kaskodenschaltung 2 dargestellt ist. Durch die Verwendung eines spannungsgesteuerten Halbleiterschalters 26 als hochsperrenden Halbleiterschalter 6 der Kaskodenschaltung 2 hat sich an der Funktionsweise der Vorrichtung 8 nichts geändert.

**Patentansprüche**

1. Verfahren zum Abschalten einer Kaskodenschaltung (2), bestehend aus einer Reihenschaltung eines nieder- und hochsperrenden Halbleiterschalters (4,6), wobei mit Eintreffen eines Abschalt-Befehls ($U_{St}$) die Gatespannung ($U_{GS}$) des niedersperrenden Halbleiterschalters (4) so geregelt wird, daß seine Drainspannung ($U_{D'S}$) konstant im aktiven Bereich des niedersperrenden Halbleiterschalters (4) der Kaskodenschaltung (2) gehalten wird.

2. Verfahren nach Anspruch 1,
   **dadurch gekennzeichnet,**
   **daß** ein Drainspannungs-Istwert ($U_{D'S}$) des niedersperrenden Halbleiterschalters (4) erfaßt und mit einem Drainspannungs-Sollwert ($U^{*}_{D'S}$) verglichen wird, und daß eine ermittelte Regelabweichung derart ausgeregelt wird, daß der erfaßte Drainspannungs-Istwert ($U_{D'S}$) dem Drainspannungs-Sollwert ($U^{*}_{D'S}$) nachgeführt wird.

3. Vorrichtung zum Abschalten einer Kaskodenschaltung (2), bestehend aus einer Reihenschaltung eines nieder- und hochsperrenden Halbleiterschalters (4,6), wobei diese Vorrichtung (8) einen Regelkreis und eine Freigabe-Einrichtung aufweist, die elektrisch in Reihe geschaltet sind, wobei an der Freigabe-Einrichtung ein Ausschalt-Befehl ($U_{St}$) ansteht, wobei dem Regelkreis ein Soll- und Istwert einer Drainspannung ($U_{D'S}$) des niedersperrenden Halbleiterschalters (4) der Kaskodenschaltung (2) zugeführt sind, und wobei der Ausgang der Vorrichtung (8) mit einem Gate-Anschluß (G) des niedersperrenden Halbleiterschalters (4) der Kaskodenschaltung (2) verknüpft ist.

4. Vorrichtung nach Anspruch 3,
   **dadurch gekennzeichnet,**
   **daß** der Regelkreis eingangsseitig einen Vergleicher (12) und ausgangsseitig einen Regler (22) aufweist, der eingangsseitig mittels einer Vorzeichenwechsel-Einrichtung (20) mit dem Ausgang des Vergleichers (12) verknüpft ist, an dessen nichtinvertierenden Eingang ein Drainspannungs-Sollwert ($U^{*}_{D'S}$) und am invertierenden Eingang ein ermittelter Drainspannungs-Istwert ($U_{D'S}$) anstehen.

5. Vorrichtung nach Anspruch 3 oder 4,
   **dadurch gekennzeichnet,**
   **daß** der Regler (22) ein Proportional-Regler ist.

6. Vorrichtung nach Anspruch 3,
   **dadurch gekennzeichnet,**
   **daß** die Freigabe-Einrichtung ein Schalter ist.

7. Vorrichtung nach einem der Ansprüche 3 bis 6,
   **dadurch gekennzeichnet,**
   **daß** der niedersperrende Halbleiterschalter (4) ein MOSFET und der hochsperrende Halbleiterschalter (6) ein JFET ist, wobei der Gate-Anschluß des JFET mittels eines Gatewiderstandes ($R_{GJ}$) mit dem Source-Anschluß (S) des MOSFET verknüpft ist.

8. Vorrichtung nach einem der Ansprüche 3 bis 6, **dadurch gekennzeichnet,**
**daß** der niedersperrende Halbleiterschalter (4) ein MOSFET und der hochsperrende Halbleiterschalter (6) ein spannungsgesteuerter Halbleiterschalter (26) ist, wobei der Gate-Anschluß des spannungsgesteuerten Halbleiterschalters (26) mittels einer Konstantspannungsquelle (28) mit dem Source-Anschluß (S) des MOSFET verknüpft ist.

9. Vorrichtung nach Anspruch 8, **dadurch gekennzeichnet,**
**daß** der spannungsgesteuerte Halbleiterschalter (26) ein Insulated-Gate-Bipolar-Transistor ist.

10. Vorrichtung nach Anspruch 8, **dadurch gekennzeichnet,**
**daß** der spannungsgesteuerte Halbleiterschalter (26) ein MOS-gesteuerter Thyristor ist.

11. Vorrichtung nach einem Ansprüche 3 bis 10, **dadurch gekennzeichnet,**
**daß** der niedersperrende Halbleiterschalter (4) aus Silizium und der hochsperrende Halbleiterschalter (6) aus Siliziumkarbid bestehen.

**Claims**

1. Method for turning off a cascode circuit (2), comprising a series circuit formed by a low-blocking-capability and high-blocking-capability semiconductor switch (4, 6), wherein when a turn-off command ($U_{St}$) arrives, the gate voltage ($U_{GS}$) of the low-blocking-capability semiconductor switch (4) is controlled in such a way that its drain voltage ($U_{D'S}$) is held in a constant manner in the active range of the low-blocking-capability semiconductor switch (4) of the cascode circuit (2).

2. Method according to Claim 1, **characterised in that** a drain voltage actual value ($U_{D'S}$) of the low-blocking-capability semiconductor switch (4) is detected and compared with a drain voltage desired value ($U_{D'S}^{*}$), and **in that** a control deviation that has been determined is corrected in such a way that the detected drain voltage actual value ($U_{D'S}$) is tracked to the drain voltage desired value ($U_{D'S}^{*}$).

3. Apparatus for turning off a cascode circuit (2), comprising a series circuit formed by a low-blocking-capability and high-blocking-capability semiconductor switch (4, 6), wherein said apparatus (8) has a control loop and an enable device which are electrically connected in series, wherein a switch-off command ($U_{St}$) is present at the enable device, wherein a desired value and actual value of a drain voltage ($U_{D'S}$) of the low-blocking-capability semiconductor switch (4) of the cascode circuit (2) are fed to the control loop, and wherein the output of the apparatus (8) is linked to a gate terminal (G) of the low-blocking-capability semiconductor switch (4) of the cascode circuit (2).

4. Apparatus according to Claim 3, **characterised in that** the control loop has, on the input side, a comparator (12) and, on the output side, a controller (22) which, on the input side, is linked by means of a sign change device (20) to the output of the comparator (12), a drain voltage desired value $U_{D'S}^{*}$ being present at the non-inverting input of said comparator and a drain voltage actual value ($U_{D'S}$) that has been determined being present at the inverting input.

5. Apparatus according to Claim 3 or 4, **characterised in that** the controller (22) is a proportional controller.

6. Apparatus according to Claim 3, **characterised in that** the enable device is a switch.

7. Apparatus according to one of Claims 3 to 6, **characterised in that** the low-blocking-capability semiconductor switch (4) is a MOSFET and the high-blocking-capability semiconductor switch (6) is a JFET, the gate terminal of the JFET being linked to the source terminal (S) of the MOSFET by means of a gate resistor ($R_{GJ}$).

8. Apparatus according to one of Claims 3 to 6, **characterised in that** the low-blocking-capability semiconductor switch (4) is a MOSFET and the high-blocking-capability semiconductor switch (6) is a voltage-controlled semiconductor switch (26), the gate terminal of the voltage-controlled semiconductor switch (26) being linked to the source terminal (S) of the MOSFET by means of a constant-voltage source (28).

9. Apparatus according to Claim 8, **characterised in that** the voltage-controlled semiconductor switch (26) is an insulated gate bipolar transistor.

10. Apparatus according to Claim 8, **characterised in that** the voltage-controlled semiconductor switch (26) is a MOS-controlled thyristor.

11. Apparatus according to one of Claims 3 to 10, **characterised in that** the low-blocking-capability semiconductor switch (4) is composed of silicon and the high-blocking-capability semiconductor switch (6) is composed of silicon carbide.

**Revendications**

1. Procédé de déconnexion d'un circuit cascode (2), constitué d'un circuit série composé d'un interrupteur semi-conducteur à point de blocage bas et d'un interrupteur semi-conducteur à point de blocage haut (4, 6), dans lequel à l'arrivée d'une instruction de déconnexion ($U_{St}$) la tension de grille ($U_{GS}$) de l'interrupteur semi-conducteur à point de blocage bas (4) est réglée de telle sorte que sa tension de drain ($U_{D'S}$) est maintenue constante dans la zone active de l'interrupteur semi-conducteur à point de blocage bas (4) du circuit cascode (2).

2. Procédé selon la revendication 1, **caractérisé par le fait qu'**on détecte une valeur réelle de tension de drain ($U_{D'S}$) de l'interrupteur semi-conducteur à blocage bas (4), qu'on la compare à une valeur de consigne de tension de drain ($U_{D'S}^{*}$) et qu'on élimine par régulation un écart de régulation déterminé de telle sorte que la valeur réelle de tension de drain détectée ($U_{D'S}$) suit la valeur de consigne de tension de drain ($U_{D'S}^{*}$).

3. Dispositif de déconnexion d'un circuit cascode (2), constitué d'un circuit série composé d'un interrupteur semi-conducteur à blocage bas et d'un interrupteur semi-conducteur à blocage haut (4, 6), dans lequel ce dispositif (8) comporte un circuit de régulation et un dispositif d'autorisation qui sont branchés électriquement en série, dans lequel une instruction de déconnexion ($U_{St}$) est présente sur le dispositif d'autorisation, dans lequel une valeur de consigne et une valeur réelle d'une tension de drain ($U_{D'S}$) de l'interrupteur semi-conducteur à blocage bas (4) du circuit cascode (2) sont envoyées au circuit de régulation et dans lequel la sortie du dispositif (8) est reliée à une borne de grille (G) de l'interrupteur semi-conducteur à blocage bas (4) du circuit cascode (2).

4. Dispositif selon la revendication 3, **caractérisé par le fait que** le circuit de régulation comporte côté entrée un comparateur (12) et côté sortie un régulateur (22) qui est relié en entrée au moyen d'un dispositif de changement de signe (20) à la sortie du comparateur (12) à l'entrée non inversée duquel se trouve une valeur de consigne de tension de drain ($U_{D'S}^{*}$) et à l'entrée inversée duquel se trouve une valeur réelle de tension de drain déterminée ($U_{D'S}$).

5. Dispositif selon la revendication 3 ou 4, **caractérisé par le fait que** le régulateur (22) est un régulateur proportionnel.

6. Dispositif selon la revendication 3, **caractérisé par le fait que** le dispositif d'autorisation est un interrupteur.

7. Dispositif selon l'une des revendications 3 à 6, **caractérisé par le fait que** l'interrupteur semi-conducteur à blocage bas (4) est un MOSFET et que l'interrupteur semi-conducteur à blocage haut (6) est un JFET, la borne de grille du JFET étant reliée au moyen d'une résistance de grille ($R_{GJ}$) à la borne de source (S) du MOSFET.

8. Dispositif selon l'une des revendications 3 à 6, **caractérisé par le fait que** l'interrupteur semi-conducteur à blocage bas (4) est un MOSFET et que l'interrupteur semi-conducteur à blocage haut (6) est un interrupteur semi-conducteur commandé en tension (26), la borne de grille de l'interrupteur semi-conducteur commandé en tension (26) étant reliée au moyen d'une source de tension constante (28) à la borne de source (S) du MOSFET.

9. Dispositif selon la revendication 8, **caractérisé par le fait que** l'interrupteur semi-conducteur commandé en tension (26) est un transistor bipolaire à grille isolée.

10. Dispositif selon la revendication 8, **caractérisé par le fait que** l'interrupteur semi-conducteur commandé en tension (26) est un thyristor à commande MOS.

11. Dispositif selon l'une des revendications 3 à 10, **caractérisé par le fait que** l'interrupteur semi-conducteur à blocage bas (4) est en silicium et l'interrupteur semi-conducteur à blocage haut (6) est en carbure de silicium.

**FIG 1**

**FIG 2**

FIG 3

FIG 4

**FIG 5**

**FIG 6**

**FIG 7**

**FIG 8**

FIG 9

**FIG 10**

**FIG 11**